# EUROPÄISCHE PATENTSCHRIFT

(11) **EP 3 319 118 B1**
(45) Veröffentlichungstag und Bekanntmachung des Hinweises auf die Patenterteilung: **19.10.2022**
(21) Anmeldenummer: 17198116.0
(22) Anmeldetag: 24.10.2017
(51) Int. Cl.: H01L 21/677, F16H 19/04, G03F 7/20, B66F 17/00, B66F 7/00

(54) **ANLAGE ZUR PROZESSIERUNG VON HALBLEITERBAUELEMENTEN SOWIE HEBEEINRICHTUNG**
INSTALLATION FOR PROCESSING SEMI-CONDUCTOR ELEMENTS AND LIFTING DEVICE
INSTALLATION DE TRAITEMENT D'ÉLÉMENTS SEMI-CONDUCTEURS AINSI QUE DISPOSITIF DE LEVAGE

(30) Priorität: 02.11.2016 DE 102016120820
(43) Veröffentlichungstag der Anmeldung: 09.05.2018
(73) Patentinhaber: Integrated Dynamics Engineering GmbH, 65479 Raunheim (DE)
(72) Erfinder: BIRKNER, Andreas, 07743 Jena (DE); EVERS, Arndt, 65375 Oestrich-Winkel (DE); SCHADT, Simon, 65195 Wiesbaden (DE)
(74) Vertreter: Blumbach · Zinngrebe Patentanwälte PartG mbB

(56) Entgegenhaltungen:
- JP-A- H0 353 193
- JP-A- H0 737 794
- JP-A- 2005 012 120
- JP-A- 2006 247 474
- JP-A- 2010 016 066
- US-A1- 2004 259 364
- US-A1- 2005 005 722
- US-A1- 2013 088 702

## Beschreibung

Die Erfindung betrifft eine Hebeeinrichtung für eine Anlage zur Prozessierung von Halbleiterbauelementen.

### Gebiet der Erfindung

Anlagen zur Prozessierung von Halbleiterbauelementen, wie Lithographieanlagen, Metrologieanlagen und sonstige Transport- und Bearbeitungseinrichtungen umfassen vielfach einen schwingungsisoliert gelagerten Granit, auf welchem Anlagenkomponenten und Module, zum Beispiel Tische angeordnet sind.

Nicht nur der Granit, sondern auch die darauf angeordneten Geräte, zum Beispiel Tische, können sehr schwer sein, was es im Servicefall schwierig macht, an die jeweiligen Komponenten heranzukommen. Ähnlich gilt das für weitere in der Anlage eingesetzte Teile.

In der Praxis werden zum Anheben von Anlagenkomponenten meist mobile Kräne verwendet. Dies ist zeitaufwendig und führt zu entsprechend teuren Standzeiten der Anlage. Mitunter ist der Einsatz eines Kranes nicht möglich, weil er in der Maschine nicht eingesetzt werden kann, oder weil er nicht an die Maschine herangefahren werden kann.

Der einschlägige Stand der Technik wird in den Dokumenten US2004/0259364-A1, US2005/0005722-A1, JP2010-016066-A und JP07-037794-A beschrieben.

### Aufgabe der Erfindung

Der Erfindung liegt demgegenüber die Aufgabe zugrunde, eine Anlage mit einer einfach handhabbaren Hebeeinrichtung bereitzustellen.

### Zusammenfassung der Erfindung

Die Aufgabe der Erfindung wird bereits durch eine Anlage zur Prozessierung von Halbleiterbauelementen gemäß den Ansprüchen 1-11 gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft eine Anlage zur Prozessierung von Halbleiterbauelementen.

Insbesondere betrifft die Erfindung eine Anlage mit einer schwingungsisoliert gelagerten Granitplatte, auf welcher ein Tisch montiert ist. Auf dem somit schwingungsisoliert gelagerten Tisch ist eine Lithographie-, Metrologie- oder Transporteinrichtung für Halbleiterbauelemente, insbesondere für Wafer, angeordnet. Weiterhin betrifft die Erfindung andere Teile der Maschine (Anlagenteile oder Anlagenmodule), welche im Servicefall oder auch bei der Montage der Maschine bewegt werden müssen.

Vorzugsweise umfasst die Anlage einen Rahmen, innerhalb dessen der schwingungsisoliert gelagerte Tisch angeordnet ist.

Die Anlage ist insbesondere zur Verwendung in Reinräumen vorgesehen.

Gemäß der Erfindung umfasst die Anlage zur Prozessierung von Halbleiterbauelementen eine Hebeeinrichtung für einen Anlagenteil oder ein Anlagenmodul, welche seitlich neben oder unter dem Anlagenteil oder dem Anlagenmodul angeordnet ist.

Insbesondere ist eine Hebeeinrichtung vorgesehen, welche beidseitig seitlich unter oder neben dem zu hebenden Anlagenteil oder Anlagenmodul angeordnet ist.

Insbesondere ist die Hebeeinrichtung an einem Rahmen der Anlage befestigt.

Mit der Hebeeinrichtung wird insbesondere eine Platte, insbesondere eine Granitplatte, angehoben, auf welcher das Anlagenteil oder Anlagenmodul angeordnet ist.

Bei einer Ausführungsform der Erfindung ist die Hebeeinrichtung fest in die Anlage integriert.

Bei einer anderen Ausführungsform ist die Hebeeinrichtung abnehmbar, insbesondere mittels eines Schnellspanners oder anderer lösbarer Verbindungen, und wird nur temporär im Servicefall oder während der Montage der Anlage angebracht.

Über eine seitlich oder unter einem Anlagenteil oder Anlagenmodul angebrachte Hebeeinrichtung können auf einfache Weise auch größere Lasten, insbesondere die Granitplatte, ggf. mit den darauf angeordneten Anlagenteilen, angehoben werden.

Vorzugsweise ist mittels der Hebeeinrichtung das Anlagenteil oder das Anlagenmodul auch in horizontaler Richtung verfahrbar.

Bei einer bevorzugten Ausführungsform der Erfindung umfasst die Anlage zwei Hebeeinrichtungen, die mittels jeweils eines einzigen Antriebs das Anlageteil oder Anlagenmodul nur in einer vertikalen Richtung und sodann nur in einer horizontalen Richtung bewegen.

Jede Hebeeinrichtung ist also derart ausgebildet, dass sie beim Anheben und Herausfahren des Anlagenteils oder Anlagenmoduls zunächst nur eine vertikale Bewegung und sodann erst eine horizontale Bewegung ausführt und/oder dass diese beim Einfahren und Absetzen eines Anlagenteils oder Anlagenmoduls zunächst eine horizontale Bewegung ausführt und im Anschluss das Anlageteil oder Anlagenmodul mit einer nur vertikalen Bewegung absetzt.

So können auch schwere Lasten präzise abgesetzt werden, insbesondere auf einem Passmittel, wie beispielsweise einem Stift der in eine Ausnehmung greift.

Bei einer bevorzugten Ausführungsform der Erfindung umfasst die Hebeeinrichtung eine Teleskopschiene.

Die Teleskopschiene dient dem horizontalen Bewegen des Anlagenteils oder des Anlagenmoduls. Es ist insbesondere vorgesehen, dass am Rahmen der Anlage seitlich zwei Teleskopschienen montiert werden, welche ihrerseits jeweils eine Einrichtung zum Anheben aufweisen, mittels der zunächst das Anlagenteil oder das Anlagenmodul angehoben wird.

Im Anschluss kann mittels der Teleskopschienen der Anlagenteil oder das Anlagenmodul seitlich aus dem Anlagenbereich herausgefahren werden.

Die Teleskopschienen umfassen vorzugsweise eine bewegliche Schiene, welche mittels zumindest zweier Keile vertikal angehoben werden kann und sodann horizontal verfahren werden kann.

Insbesondere bei einer Teleskopschiene mit einer Länge von mehr als 1 m können auch mehr Keile vorhanden sein, um auch große und schwere Anlagenteile oder Anlagenmodule bewegen zu können.

Der Anlagenbereich ist insbesondere als der Bereich gekennzeichnet, der vom Rahmen der Anlage umschlossen wird.

Bei einer Weiterbildung der Erfindung umfasst die Teleskopschiene zwei ineinandergreifende und übereinander liegende Zahnräder, wobei die Zahnräder jeweils in eine Zahnstange greifen, die an einer Schiene angeordnet ist.

Es ist insbesondere vorgesehen, dass an einem beweglichen Teil der Teleskopschiene die Zahnstangen angeordnet sind.

Beim Ausziehen der beweglichen Schiene laufen beide ineinandergreifenden Zahnräder in den sich gegenüberliegenden Zahnschienen. Durch die ineinandergreifenden Zahlschienen wird ein Formschluss von der oberen Zahnstange zur unteren Zahnstange erzielt

Auf diese Weise wird eine sehr hohe vertikale Steifigkeit der beweglichen Schiene erreicht. Die Zahnräder entsprechen einem virtuellen Hebel, der dem zweifachen Zahnraddurchmesser entspricht.

Zur Bereitstellung einer vertikalen Bewegung, also zum Anheben eines Anlagenteils oder Anlagenmoduls kann die Teleskopschiene einen Keil umfassen. Der Keil kann an einem stationären Teil der Teleskopschiene angebracht sein, und beispielsweise über eine Spindel bewegt werden. Der bewegliche Teil der Teleskopschiene gleitet zunächst über den Keil und hebt dabei das Anlagenteil oder Anlagenmodul an. Anschließend erfolgt eine rein horizontale Bewegung.

Es ist insbesondere bei einer Ausführungsform der Erfindung vorgesehen, dass nach dem Anheben des beweglichen Teils der Teleskopschiene die ineinandergreifenden Zahnräder in die Zahnstangen greifen.

Vorzugsweise ist die Teleskopschiene derart ausgebildet, dass beim Ausfahren des Anlagenteils oder Anlagenmoduls die Schiene mit den Zahnstangen erst angehoben wird, so dass sie auf einer Höhe liegt, auf welcher die Zahnräder in die Zahnstangen greifen können. Sodann wird die Schiene horizontal verfahren. Die kann z.B. realisiert werden, indem die Schiene über einen Keil angehoben und sodann über einen Mitnehmer horizontal verfahren wird.

Vorzugsweise ist die Hebeeinrichtung derart ausgebildet, dass sie bei Betätigung eines einzigen Handhabungsmittels eine vertikale und horizontale Bewegung ausführt, wobei diese vertikale und horizontale Bewegung in verschiedenen Bewegungsabschnitten ausgeführt werden kann.

Es ist insbesondere vorgesehen, dass die Hebeeinrichtung einen Antrieb mit einer Gewindespindel umfasst.

Die Gewindespindel kann mit einer Handhabungseinrichtung, beispielsweise mit einer Kurbel oder mit einem Schlüssel, gedreht werden. Durch das Drehen der Gewindespindel wird zunächst ein Anlagenmodul oder Anlagenteil angehoben und anschließend horizontal verfahren.

Die Hebeeinrichtung kann, wie es bei einer bevorzugten Ausführungsform vorgesehen ist, trockenlaufende, also ohne Schmiermittel laufende, Gleit- oder Kugellager umfassen. Diese können mit einer die Reibung reduzierenden Beschichtung, beispielsweise mit einer Diamond-like-Carbon-Beschichtung, versehen sein.

Weiter können verschieden Komponenten der Hebeeinrichtung über Getriebe miteinander synchronisiert sein, wodurch sie eine einander entsprechende Bewegung ausführen. Denkbar sind ferner synchron arbeitende Antriebe, wie beispielsweise Elektroantriebe.

Vorzugsweise werden mehrere Hebemodule synchron bewegt.

Anstelle eines Keils zum Anheben der Last können auch Hebelarme oder sonstige Hubvorrichtungen vorgesehen sein.

Bei einer weiteren Ausführungsform der Erfindung sind Passmittel vorgesehen, um die angehobene und/oder bewegte Last beim Absetzen wieder genau an derselben Stelle zu positionieren. Derartige Passmittel können insbesondere einen Stift und eine korrespondierende Ausnehmung umfassen.

### Kurzbeschreibung der Zeichnungen

Der Gegenstand der Erfindung soll im Folgenden bezugnehmend auf schematisch dargestellte Ausführungsbeispiele anhand der Zeichnungen Fig. 1 bis Fig. 28 näher erläutert werden.
Fig. 1 zeigt eine perspektivische Ansicht einer Anlage zur Prozessierung von Halbleiterbauelementen, welche eine Hebeeinrichtung umfasst.
Bezugnehmend auf Fig. 8 und Fig. 9 soll das Herausheben eines Anlagenmoduls oder Anlagenteils aus dem Anlagenbereich näher erläutert werden.
Fig. 4 bis Fig. 18 sind perspektivische Ansichten einer Hebeeinrichtung gemäß einer ersten Ausführungsform der Erfindung.
Fig. 19 und Fig. 20 sind perspektivische Ansichten eines Anlagenteils, in welchem Passmittel angeordnet sind.
Fig. 21 und Fig. 22 sind perspektivische Ansichten eines alternativen Ausführungsbeispiels einer Hebeeinrichtung, welche nur eine vertikale Bewegung ausführt.
Fig. 23 und Fig. 24 zeigen in jeweils einer perspektivischen Ansicht ein erstes Ausführungsbeispiel, wie eine derartige vertikale Bewegung realisiert wird.
Fig. 25 und Fig. 26 zeigen ein weiteres Ausführungsbeispiel einer Ausführungsform zum Ausführen einer vertikalen Bewegung.
Fig. 27 und Fig. 28 sind Detailansichten einer Anlage zur Prozessierung von Halbleiterbauelementen, in die die in Fig. 21 und Fig. 22 gezeigte Hebeeinrichtung eingebaut ist.

### Detaillierte Beschreibung der Zeichnungen

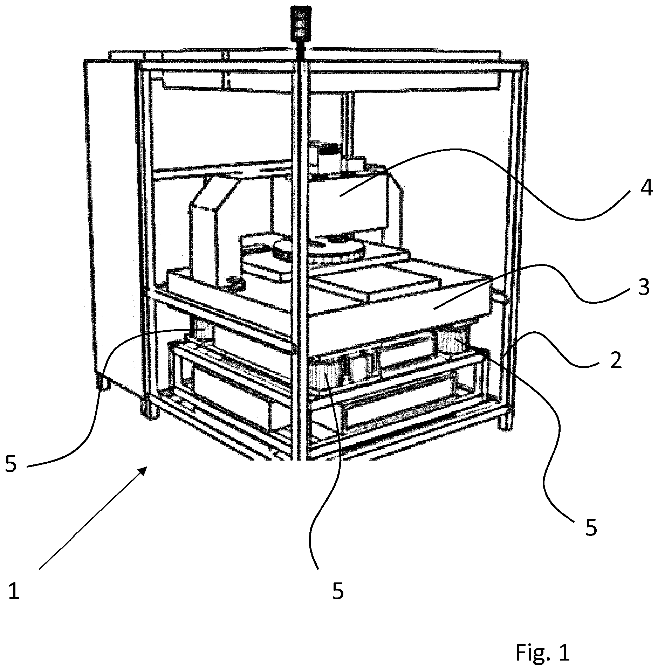

Fig. 1 zeigt in einer perspektivischen Ansicht eine Anlage 1 zur Prozessierung von Halbleiterbauelementen.

Die Anlage 1 umfasst einen Rahmen 2, welcher den Anlagenbereich umschließt.

Innerhalb des Anlagenbereichs ist auf horizontal und vertikal wirksamen Isolatoren 5 eine Platte 3 schwingungsisoliert gelagert. Die Platte 3 kann insbesondere als ein Granitblock ausgebildet sein.

Auf der Platte 3 ist in diesem Ausführungsbeispiel ein Inspektionsgerät 4 angeordnet.

Die auf den Isolatoren 5 gelagerte Platte 3 bildet mit dem Inspektionsgerät 4 ein Anlagenmodul.

Im Servicefall kann es nunmehr sein, dass Teile des Anlagenmoduls, beispielsweise die Platte 3 mit dem Inspektionsgerät 4, herausgefahren werden müssen.

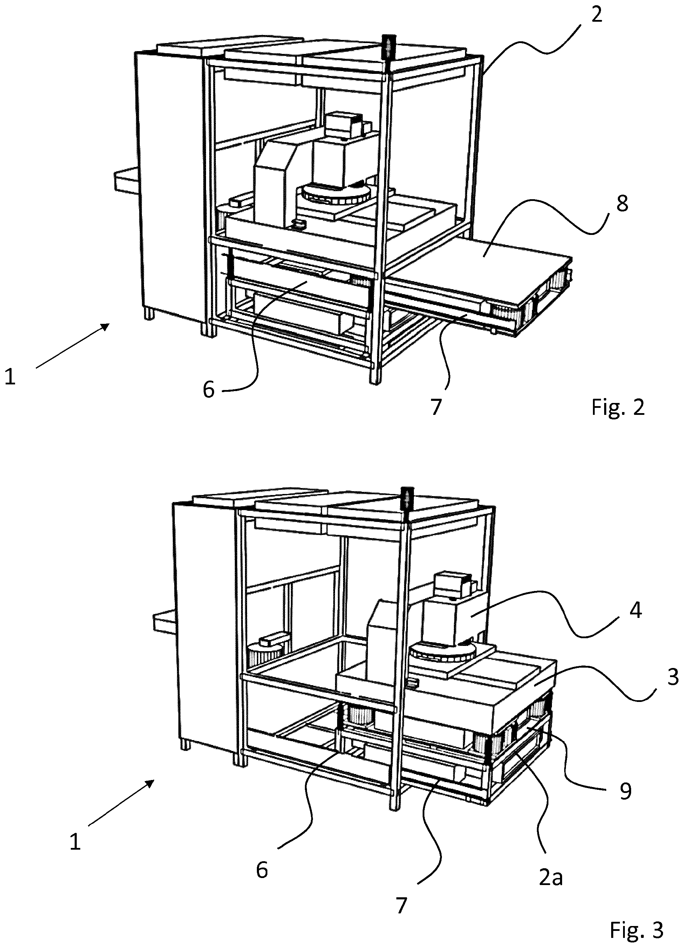

Fig. 2 zeigt in einer perspektivischen Ansicht, wie mittels einer Hebeeinrichtung 6 ein Anlagenteil 8 aus dem Anlagenbereich teilweise herausgefahren ist.

Die Hebeeinrichtung 6 ist in diesem Ausführungsbeispiel als Teleskopschiene ausgebildet und umfasst die bewegliche Schiene 7, welche herausgefahren ist und das Anlagenteil 8 trägt.

Die Hebeeinrichtung 6 ist in diesem Fall am Innenrahmen 2a der Anlage 1 seitlich neben dem Anlagenteil 8 angeordnet und umfasst zwei sich gegenüberliegende Teleskopschienen.

Wie in Fig. 3 zu erkennen ist, kann die Hebeeinrichtung 6 an verschiedenen Stellen der Anlage montiert werden.

In diesem Ausführungsbeispiel ist die Teleskopschiene nicht am Innenrahmen 2a befestigt, sondern am Rahmen 2.

Hierdurch kann das gesamte Anlagenmodul mit der Platte 3 und dem Inspektionsgerät 4 aus dem Anlagenbereich herausgefahren werden, indem wiederum die bewegliche Schiene 7 der Teleskopschiene herausgefahren wird.

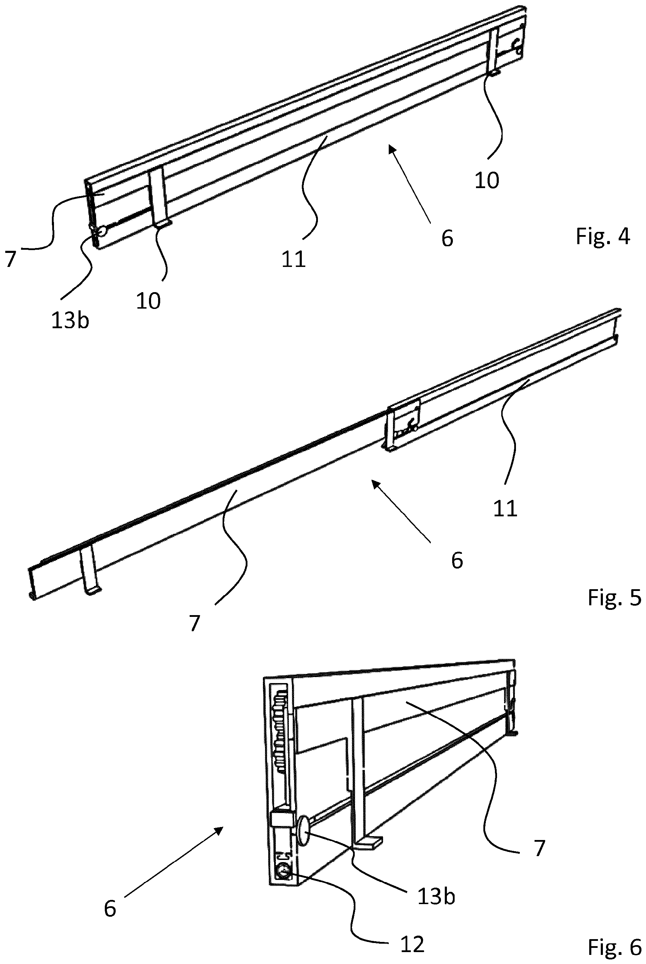

Bezugnehmend auf Fig. 4 bis Fig. 18 soll eine erste Ausführungsform einer Hebeeinrichtung 6 näher erläutert werden, welche eine Teleskopschiene umfasst.

Fig. 4 zeigt eine perspektivische Ansicht einer Hebeeinrichtung 6. Diese ist als Teleskopschiene ausgebildet und umfasst eine bewegliche Schiene 7 sowie eine Schiene 11, welche an dem Rahmen der Anlage (2 in Fig. 1) angebracht werden kann, oder welche am Innenrahmen (2a in Fig. 3) angebracht werden kann.

An der beweglichen Schiene 7 sind Lastaufnahmen 10 angebracht, welche in diesem Ausführungsbeispiel als Winkel ausgebildet sind.

An der stationären Schiene 11 ist eine Rolle angebracht, auf welcher die bewegliche Schiene 7 beim Ausfahren läuft, was im Folgenden noch im Detail erläutert wird.

Fig. 5 zeigt eine perspektivische Darstellung, in welcher die bewegliche Schiene 7 aus der Schiene 11 herausgefahren ist. Zu erkennen ist, dass nur noch ein kleiner Teil der Schiene 7, welcher weniger als 1/4 der Länge der Schiene 7 beträgt, in die Schiene 11 hineingefahren ist.

Weiter wurde die bewegliche Schiene 7 gegenüber der in Fig. 4 dargestellten eingefahrenen Ruheposition nach oben angehoben, um das Anlagenteil oder das Anlagenmodul von anderen Bauteilen abzuheben und herauszufahren.

Fig. 6 ist eine weitere perspektivische Ansicht der Hebeeinrichtung 6. Diese umfasst stirnseitig ein Handhabungsmittel 12. Das Handhabungsmittel 12 ist in dieser Ausführungsform als Antrieb für einen Steckschlüssel oder eine Kurbel ausgebildet. Das Handhabungswerkzeug wird in das Handhabungsmittel 12 hineingesteckt. Durch Drehen des Handhabungsmittels wird die bewegliche Schiene 7 angehoben und sodann herausgefahren.

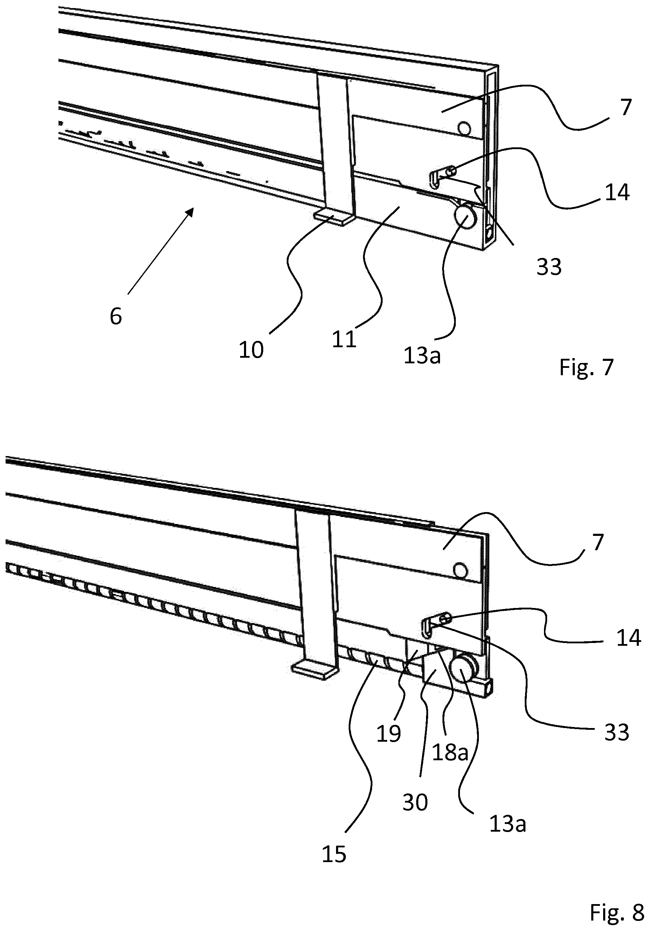

Fig. 7 ist eine Detaildarstellung des vorderen Teils der Hebeeinrichtung 6.

Zu erkennen ist eine Lastaufnahme 10.

Weiter ist die stationäre Schiene 11 zu erkennen.

Die bewegliche Schiene 7 umfasst hinten die Rolle 13a, die beim Herausfahren auf der stationären Schiene 11 läuft.

Weiter zu erkennen ist für die horizontale Bewegung ein Mitnehmer 14, der nach dem Anheben der Last die bewegliche Schiene 7 in horizontaler Richtung weiterbewegt.

Der Mitnehmer 14 ist in diesem Ausführungsbeispiel als Stift ausgebildet, der in ein Langloch 33 der beweglichen Schiene 11 greift.

Fig. 8 ist eine weitere perspektivische Ansicht, bei welcher die stationäre Schiene ausgeblendet ist.

Zu erkennen ist die horizontal verlaufende Gewindespindel 15, welche über das Handhabungsmittel (12 in Fig. 6) angetrieben wird.

Über die Gewindespindel 15 wird der Schlitten 30 bewegt.

Zum Herausfahren der beweglichen Schiene 7 wird die Schiene 7 zunächst angehoben, indem der Schlitten 30 mit dem Keil 18a das Gleitelement 19, welches an der beweglichen Schiene 7 angebracht ist, nach oben drückt. Die bewegliche Schiene 7 wird so einschließlich der Rolle 13a angehoben.

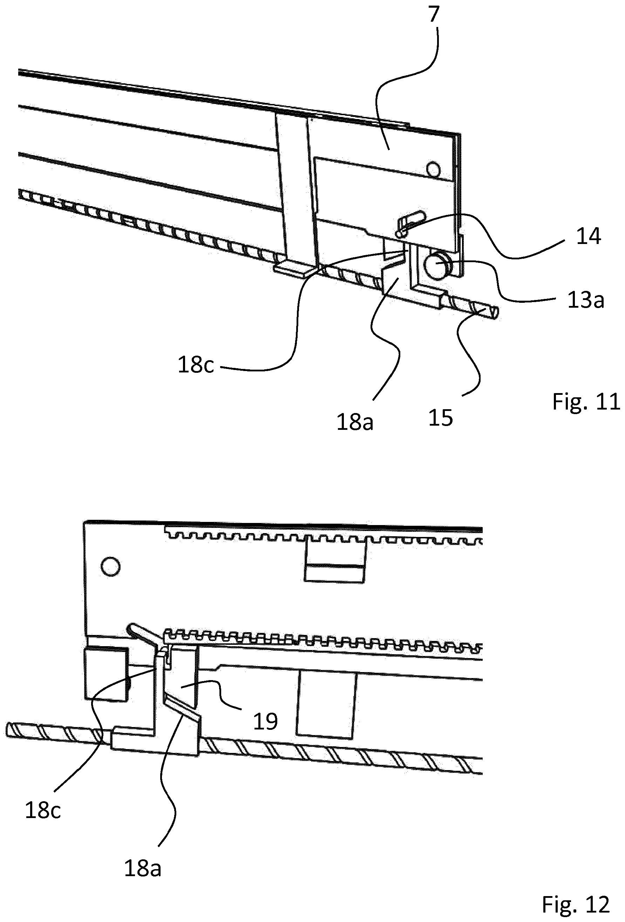

Im Anschluss, also nach einer rein vertikalen Bewegung, nimmt der horizontale Mitnehmer 18c (siehe Fig. 12) die bewegliche Schiene 7 in horizontaler Richtung herausfahrend mit und verfährt diese mit der zu bewegenden Last aus dem Anlagenbereich heraus. Bei der hereinfahrenden Bewegung hingegen wird die bewegliche Schiene 7 durch den Mitnehmer 14 mitgenommen.

Das Langloch 33 umfasst einen vertikal und einen schräg verlaufenden Abschnitt. Beim Anheben über die Keile passiert der Mitnehmer 14 zunächst den schräg verlaufenden Abschnitt. Dabei bewegt sich die bewegliche Schiene nur nach oben, später schräg. Der Mitnehmer 14 hat die Funktion, beim Hereinfahren die bewegliche Schiene 7 mitzunehmen. Das Langloch 33 hat die dargestellte Form, um das relative horizontale und vertikale Bewegungsprofil des Mitnehmers 14 zum beweglichen Teil der Schiene 7 zu ermöglichen.

Die bewegliche Schiene 7 läuft dabei hinten auf der an der beweglichen Schiene angebrachte Rolle 13a auf dem feststehenden Teil der Schiene 11.

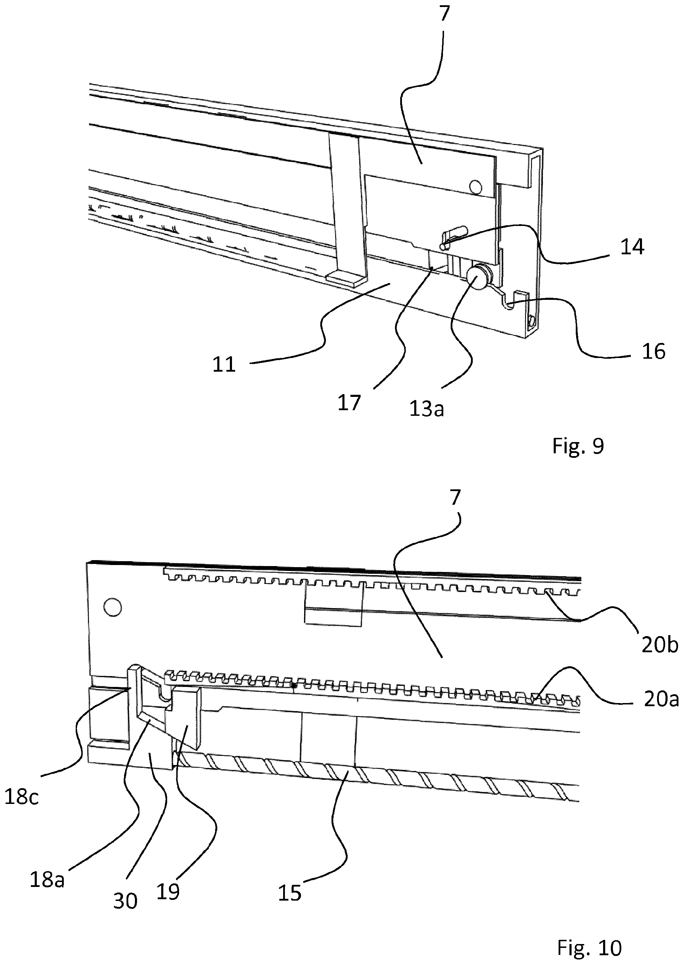

Fig. 9 zeigt eine weitere Ansicht, in der man die Lauffläche 17 für die Rolle 13a der Schiene 11 erkennt.

Weiter zu erkennen ist die am Ende angeordnete Einsenkung 16, in welche die Rolle 13a im eingefahrenen Zustand einsinken kann, wenn die bewegliche Schiene 7 vertikal abgesetzt wird.

In dieser Position ist die bewegliche Schiene 7 bereits angehoben und wird vom beim Herausfahren über den horizontalen Mitnehmer 18c weiterbewegt. Die Rolle 13a läuft beim Herausfahren auf der Lauffläche 7 der stationären Schiene 11.

Fig. 10 ist eine perspektivische Detailansicht auf die der Fig. 9 gegenüberliegende Seite der Hebeeinrichtung.

Zu erkennen ist, dass auf der gegenüberliegenden Seite die bewegliche Schiene 7 zwei Zahnstangen 20a, 20b umfasst, welche sich gegenüberliegen.

Weiter zu erkennen ist ein Keil 18a, der Teil des Schlittens 30 ist, welcher über die Gewindespindel 15 verfahren wird und welcher auch den horizontalen Mitnehmer 18c umfasst.

Über den Keil 18a und das Gleitelement 19 wird beim Betätigen der Gewindespindel 15 die bewegliche Schiene 7 zunächst angehoben. Anschließend wird sie beim Herausfahren über den horizontalen Mitnehmer 18c in horizontaler Richtung bewegt.

Fig. 11 ist eine Darstellung, bei der man den Keil 18a, die Rolle 13a und den Mitnehmer 14 von der gegenüberliegenden Seite sieht. In diesem Zustand ist die bewegliche Schiene 7 bereits angehoben und der horizontale Mitnehmer 18c beginnt die bewegliche Schiene 7 in horizontaler Richtung herausfahrend zu verfahren (hereinfahrend wird die bewegliche Schiene 7 vom Mitnehmer 14 verfahren).

Fig. 12 entspricht der Ansicht gemäß Fig. 10, wobei über den Keil 18a das Gleitelement 19 angehoben wurde, und zusätzlich auch gleichzeitig über die Schräge der Einsenkung 16 angehoben wurde.

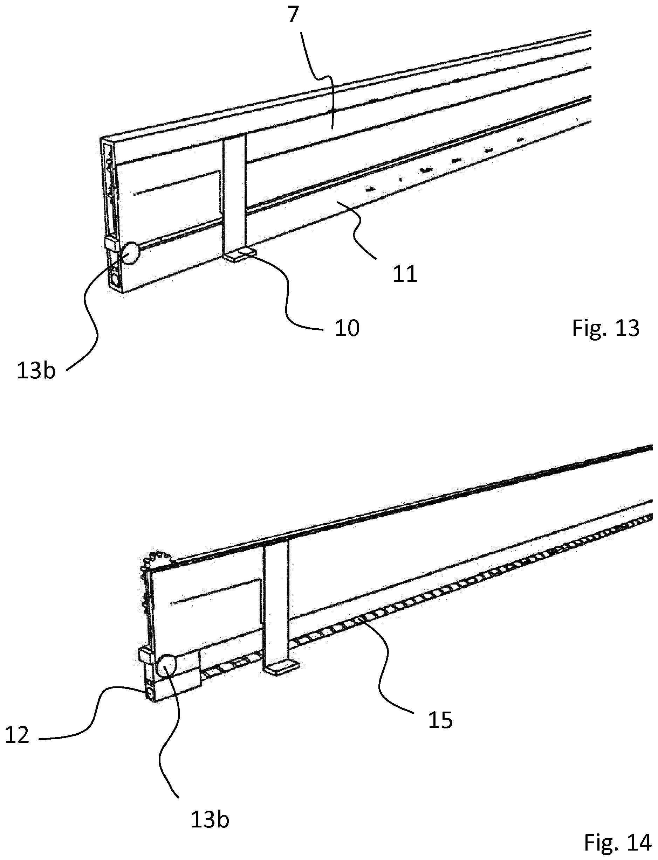

Fig. 13 bis Fig. 18 zeigen den den Ansichten Fig. 7 bis Fig. 12 gegenüberliegenden vorderen Teil der Hebeeinrichtung.

Zu erkennen ist in der Ansicht gemäß Fig. 13, dass auch auf der gegenüberliegenden Seite eine Rolle 13b vorgesehen ist. Diese Rolle 13b ist im Unterschied zur hinteren Rolle (13a) aber nicht mit der beweglichen Schiene 7, sondern mit der stationären Schiene 11 verbunden.

Beim Herausfahren läuft die bewegliche Schiene 7 also vorne auf der Rolle 13a.

Weiter zu erkennen ist in Fig. 14, dass sich die Gewindespindel 15 nahezu über die gesamte Länge der Hebeeinrichtung bis zum Handhabungsmittel 12 erstreckt.

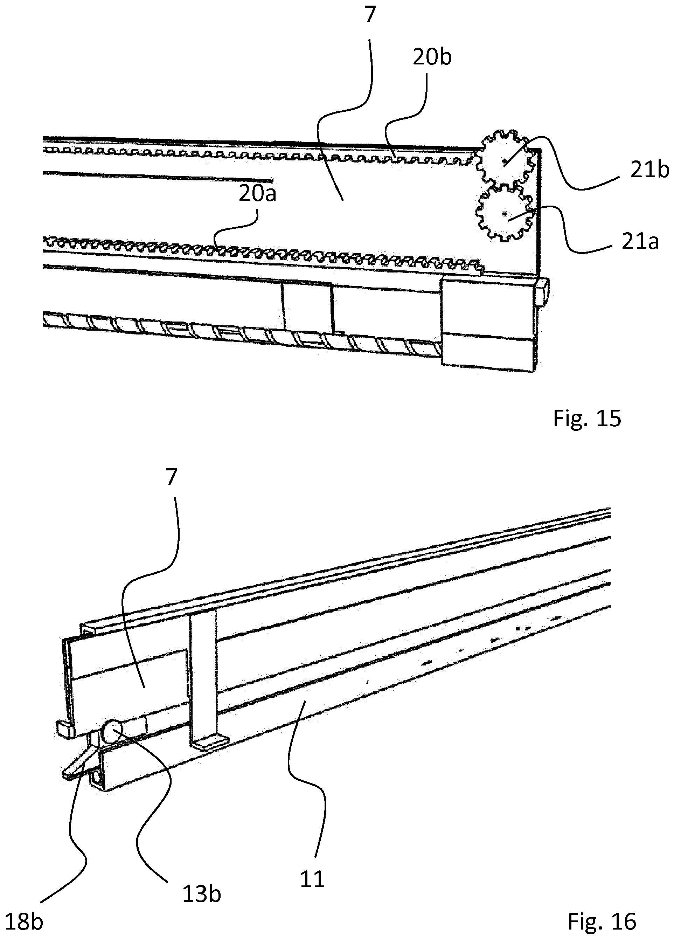

Fig. 15 zeigt die der Fig. 14 gegenüberliegende Seite der Hebeeinrichtung, wobei die stationäre Schiene ausgeblendet ist.

An der stationären Schiene (ausgeblendet), welche die bewegliche Schiene 7 umgreift sind zwei ineinandergreifende Zahnräder 21a, 21b angebracht.

Fig. 15 zeigt den eingefahrenen Zustand der Hebeeinrichtung. Die Zahnräder 21a und 21b befinden sich beide neben den Zahnstangen 20a und 20b der beweglichen Schiene 7 und greifen nicht in diese ein.

In der Darstellung gemäß Fig. 16 ist zu erkennen, dass auch auf dieser vorderen Seite ein Keil 18b vorhanden ist, über welchen die Schiene 7 vor dem Verfahren in horizontaler Richtung angehoben wird.

In der Darstellung gemäß Fig. 16 ist die stationäre Schiene 11 zumindest teilweise zu erkennen.

Zu erkennen ist der Keil 18b, welcher auch über die Gewindespindel 15 verfahren wird (wie der in Fig. 10 dargestellte Mitnehmer 30). Weiter zu erkennen ist die Rolle 13b.

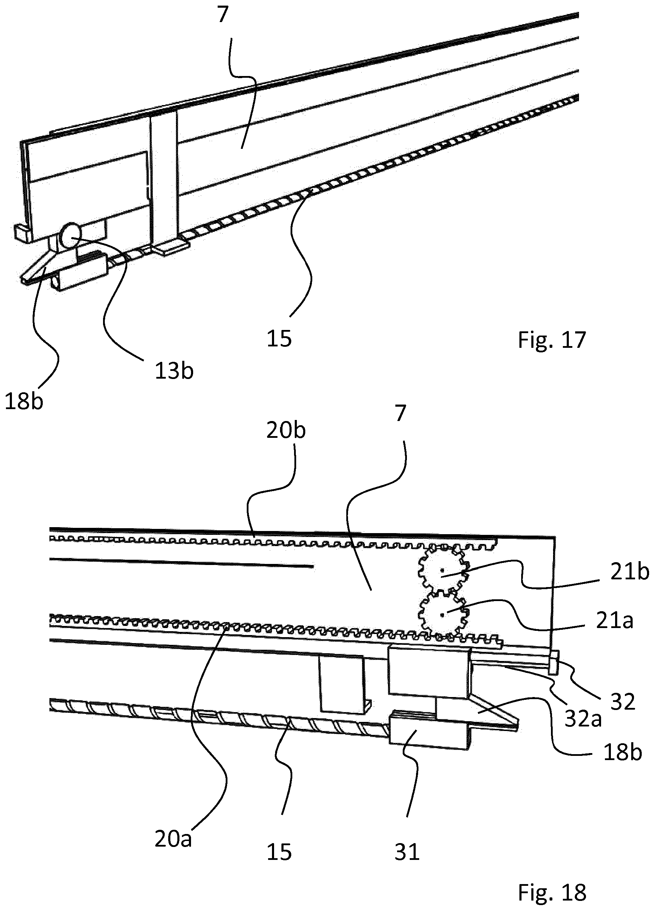

In der Darstellung gemäß Fig. 17 ist die stationäre Schiene ausgeblendet. Zu erkennen ist, wie der Keil 18b die bewegliche Schiene 7 angehoben hat.

Fig. 18 zeigt nunmehr, wie die bewegliche Schiene 7 über die Keile 18a und 18b angehoben wurde.

Beim Herausfahren wird die Bewegung des Keils 18b nach dem Anheben beendet, da der auf dem nicht beweglichen Schlitten 31 laufende Keil 18b aus dem Gewinde der Gewindespindel 15 läuft. Beim Einfahren bewegt am Ende des Einfahrvorgangs der stirnseitig an der beweglichen Schiene 7 angebrachte Mitnehmer 32 mit dem Mitnehmerstab 32a den Keil 18b zurück auf das Gewinde, so dass dieser mitgenommen wird und die Schiene 7 über den Keil 18b nach dem Einfahren abgesenkt wird.

Nach dem Anheben wurde in dieser Ansicht die Schiene 7 schon ein Stück in horizontaler Richtung bewegt, so dass nunmehr die am stationären Teil angebrachten Zahnräder 21a und 21b in die Zahnstangen 20a und 20b greifen.

Über die ineinandergreifenden Zahnräder 21a und 21b, welche in die Zahnstangen 20a und 20b greifen, kann eine hohe vertikale Steifigkeit der beweglichen Schiene 7 erreicht werden.

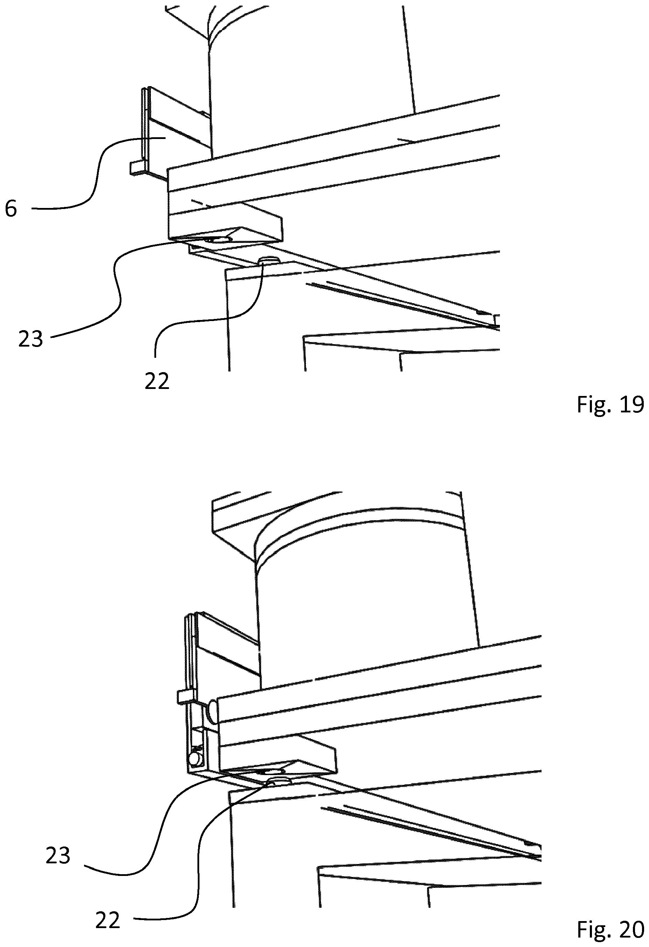

Fig. 19 und Fig. 20 sind perspektivische Detaildarstellungen, in denen zu erkennen ist, dass der anzuhebende Teil der Anlage mittels Passmitteln positioniert werden kann. Da am Ende des Einfahrvorgangs der anzuhebende Teil nur in vertikaler Richtung bewegt wird, lässt sich dieser besonders exakt auf einem Passmittel positionieren.

Zu erkennen ist, dass in diesem Ausführungsbeispiel die zu bewegende Last eine Ausnehmung 23 aufweist, die mit einem Stift 22 korrespondiert, die am nicht zu bewegenden Anlagenteil angebracht ist.

Fig. 19 zeigt nunmehr, wie die zu bewegende Last mittels der Hebeeinrichtung 6 angehoben und horizontal verfahren wurde.

Fig. 20 zeigt, wie die zu bewegende Last abgesetzt wird. Die Ausnehmung 23 ist nunmehr schon unmittelbar über dem Stift 22 angeordnet und wird beim weiteren Absenken durch ein Ineinandergreifen von Stift und Ausnehmung, welche ein Passmittel bilden, positioniert.

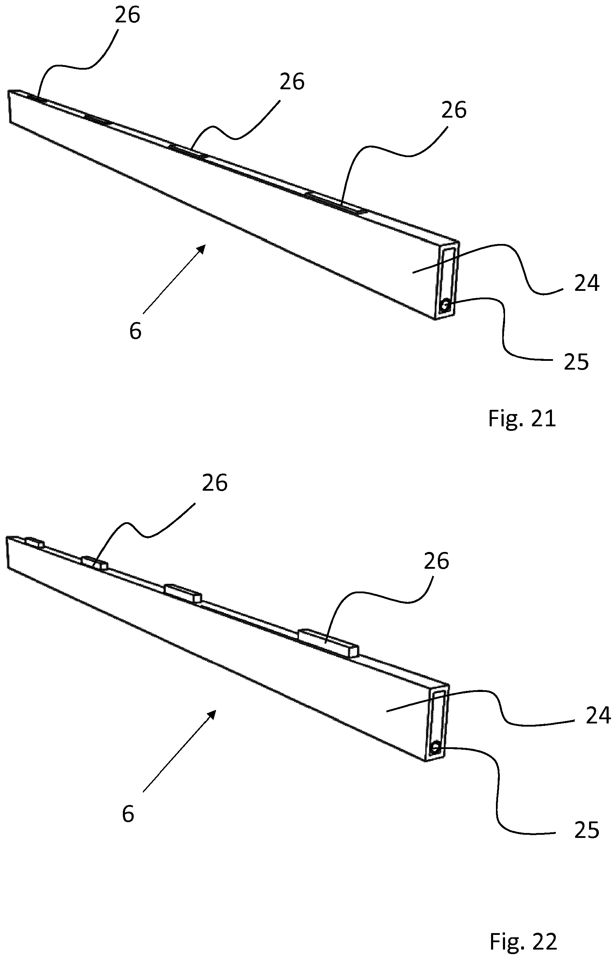

Fig. 21 und Fig. 22 sind perspektivische Ansichten eines weiteren Ausführungsbeispiels einer Hebeeinrichtung 6, mittels der nur eine vertikale Bewegung möglich ist.

Zu erkennen ist, dass auch diese Hebeeinrichtung 6 eine Schiene 24 umfasst, welche am Rahmen einer Anlage zur Prozessierung von Halbleiterbauelementen positioniert werden kann.

Insbesondere wird eine derartige Schiene 24 an zwei Seiten, die sich gegenüberliegen, am Rahmen der Anlage befestigt.

Zu sehen ist, dass aus der Schiene 24 eine Mehrzahl von Stempeln 26 herausragen, über welche die zu bewegende Last angehoben werden kann.

Zum Herausfahren der Stempel 26 ist ebenfalls ein Handhabungsmittel 25 vorgesehen, welches mit einem Schlüssel oder einem Gewinde gedreht werden kann.

Fig. 22 zeigt den Zustand der Hebeeinrichtung im angehobenen Zustand.

Zu erkennen ist, dass die Stempel 26 nunmehr aus der Schiene 24 herausragen. Diese haben in diesem Zustand die zu bewegende Last angehoben, und zwar an mehreren Stellen parallel, so dass ein Verbiegen der Last durch das anheben ausgeschlossen ist.

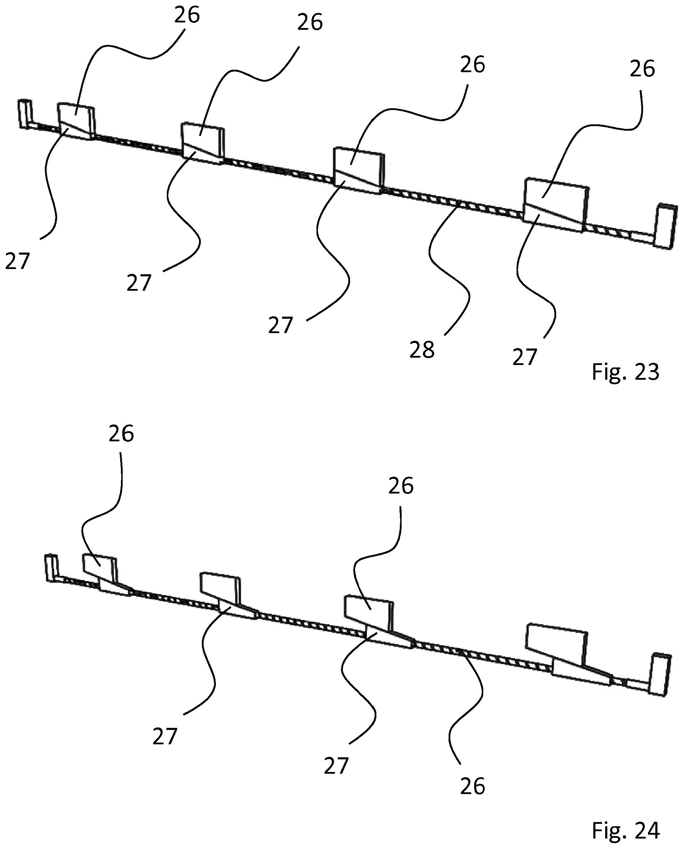

Fig. 23 und Fig. 24 zeigen ein erstes Ausführungsbeispiel, wie ein Anheben der Stempel 26 auf einfache Weise realisiert werden kann.

Hierzu ist, wie in Fig. 23 zu sehen, unter jedem Stempel ein Keil 27 angeordnet.

Die Keile 27 können mit der Gewindespindel 28 bewegt werden.

Wie in Fig. 24 dargestellt, gleiten so die Keile 27 unter den Stempeln 26 entlang. Zwischen Stempel 26 und Keil 27 befindet sich also eine Gleitfläche, über die der jeweilige Stempel 26 nach oben bewegt wird.

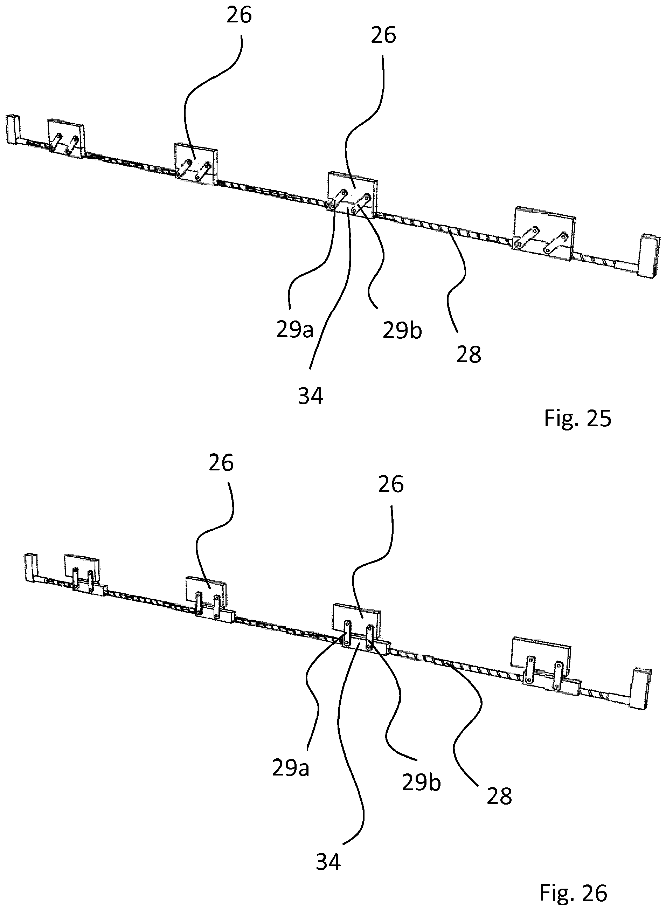

Fig. 25 und Fig. 26 zeigen eine alternative Variante, wie die Stempel 26 nach oben bewegt werden können.

Hier sind jeweils zwei Hebelarme 29a, 29b vorgesehen, über die der jeweilige Stempel mit einem Läufer 34 verbunden ist.

Wie nunmehr in Fig. 26 dargestellt, werden die Läufer 34 über die Gewindespindel 28 bewegt. Hierdurch richten sich die Hebelarme 29a, 29b auf und bewegen die Stempel 26, welche in der Schiene (24 in Fig. 21 und Fig. 22) geführt sind, nach oben.

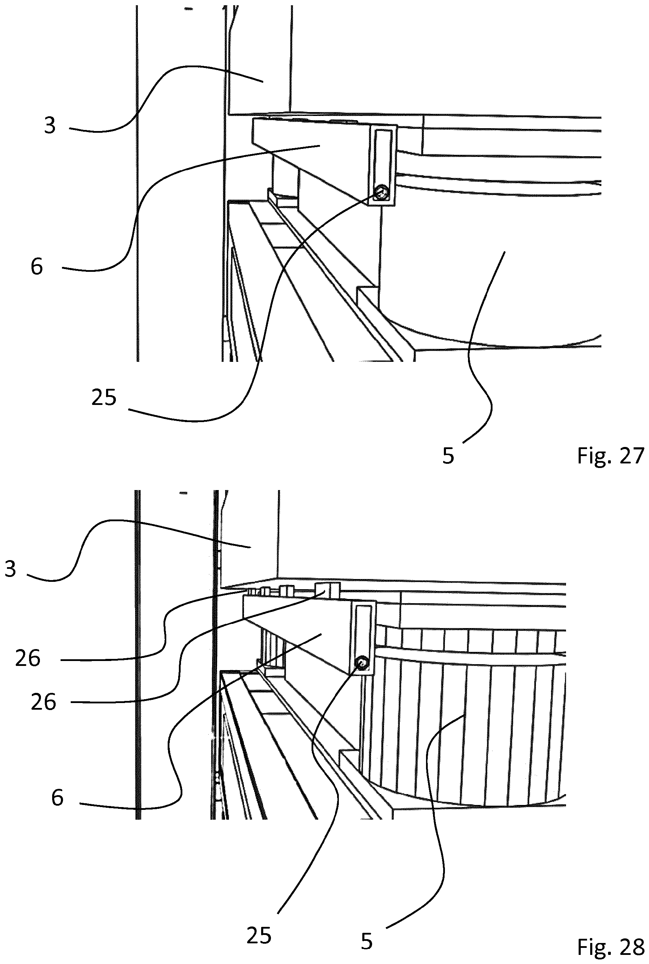

Fig. 27 und Fig. 28 sind perspektivische Detaildarstellungen, in denen die in Fig. 21 und Fig. 22 dargestellte Hebeeinrichtung in eine Anlage zur Prozessierung von Halbleiterbauelementen eingebaut ist. Die Befestigung der Hebeeinrichtung an einem Rahmen ist hier nicht dargestellt.

Zu erkennen ist, dass die Hebeeinrichtung 6 unterhalb der Platte 3, welche auf den Isolatoren 4 ruht, montiert ist.

Über ein Drehen des Handhabungsmittels 25 werden, wie in Fig. 28 dargestellt, die Stempel 26 nach oben gefahren und heben die Platte 3 von den Isolatoren 5 ab.

Durch die Erfindung können auch schwere Anlagenteile einer Anlage zur Prozessierung von Halbleiterbauelementen bewegt werden.

### Bezugszeichenliste:

- 1: Anlage zur Prozessierung von Halbleiterbauelementen
- 2: Rahmen
- 2a: Innenrahmen
- 3: Platte
- 4: Inspektionsgerät
- 5: Isolator
- 6: Hebeeinrichtung
- 7: Schiene
- 8: Anlagenteil
- 9: Anlagenmodul
- 10: Lastaufnahme
- 11: Schiene
- 12: Handhabungsmittel
- 13a,13b: Rolle
- 14: Mitnehmer
- 15: Gewindespindel
- 16: Einsenkung
- 17: Lauffläche
- 18a,18b: Keil
- 18c: Horizontaler Mitnehmer
- 19: Gleitelement
- 20a,20b: Zahnstange
- 21a, 21b: Zahnrad
- 22: Stift
- 23: Ausnehmung
- 24: Schiene
- 25: Handhabungsmittel
- 26: Stempel
- 27: Keil
- 28: Gewindespindel
- 29a, 29b: Hebelarm
- 30: Schlitten
- 31: Schlitten
- 32: Mitnehmer
- 32a: Mitnehmerstab
- 33: Langloch
- 34: Läufer

## Patentansprüche

1. Anlage (1) zur Prozessierung von Halbleiterbauelementen, umfassend eine Hebeeinrichtung (6) für ein Anlagenteil (8) oder ein Anlagenmodul (9), welche seitlich neben oder unter oder über dem Anlagenteil (8) oder dem Anlagenmodul (9) angebracht ist, wobei die Hebeeinrichtung (6) eine Teleskopschiene zum horizontalen Bewegen des Anlagenteils (8) oder Anlagenmoduls (9) umfasst, und wobei die Teleskopschiene eine bewegliche Schiene (7) umfasst, welche über Keile (18a, 18b) anhebbar ist.

2. Anlage (1) zur Prozessierung von Halbleiterbauelementen nach dem vorstehenden Anspruch, **dadurch gekennzeichnet, dass** die Anlage (1) zumindest eine, vorzugsweise zwei Hebeeinrichtungen (6) umfasst, die mittels jeweils eines einzigen Antriebs das Anlageteil (8) oder Anlagenmodul (9) nur in einer vertikalen Richtung und sodann nur in einer horizontalen Richtung bewegen.

3. Anlage (1) zur Prozessierung von Halbleiterbauelementen nach dem vorstehenden Anspruch, **dadurch gekennzeichnet, dass** die Teleskopschiene zumindest zwei ineinandergreifende und übereinander angeordnete Zahnräder (21a, 21b) umfasst, wobei die Zahnräder (21a, 21b) jeweils in eine Zahnstange (20a, 20b) der beweglichen Schiene (7) greifen.

4. Anlage (1) zur Prozessierung von Halbleiterbauelementen nach einem der vorstehenden Ansprüche, **dadurch gekennzeichnet, dass** die Hebeeinrichtung (6) derart ausgebildet ist, dass sie bei Betätigung eines einzigen Handhabungsmittels (12) eine vertikale und horizontale Bewegung ausführt.

5. Anlage (1) zur Prozessierung von Halbleiterbauelementen nach einem der vorstehenden Ansprüche, **dadurch gekennzeichnet, dass** die Hebeeinrichtung eine Länge von mehr als 1 m hat.

6. Anlage (1) zur Prozessierung von Halbleiterbauelementen nach einem der vorstehenden Ansprüche, **dadurch gekennzeichnet, dass** die Hebeeinrichtung (6) einen Antrieb mit einer Gewindespindel (15) umfasst.

7. Anlage (1) zur Prozessierung von Halbleiterbauelementen nach Anspruch 1, **dadurch gekennzeichnet, dass** die Hebeeinrichtung (6) zumindest einen, vorzugsweise zwei, besonders bevorzugt eine Vielzahl von Stempeln (26) umfasst, welche über Keile (27) und/oder Hebelarme (29a, 29b) vertikal bewegbar sind.

8. Anlage (1) zur Prozessierung von Halbleiterbauelementen nach dem vorstehenden Anspruch, **dadurch gekennzeichnet, dass** die Hebeeinrichtung (6) eine Schiene (24) umfasst, aus welcher die Stempel (26) zumindest in einem angehobenen Zustand herausragen.

9. Anlage (1) zur Prozessierung von Halbleiterbauelementen nach einem der vorstehenden Ansprüche, **dadurch gekennzeichnet, dass** die Hebeeinrichtung (6) abnehmbar ausgebildet ist, insbesondere mittels einer Schnellspanneinrichtung.

10. Anlage (1) zur Prozessierung von Halbleiterbauelementen nach einem der vorstehenden Ansprüche, **dadurch gekennzeichnet, dass** die Hebeeinrichtung als Teleskopschiene ausgebildet ist und wobei zwei oder mehr Zahnräder (21a, 21b) in Verbindung mit zwei Zahnschienen (20a, 20b) oder Verzahnungen einen Hebel bilden, der die Steifigkeit des Systems aus feststehender und beweglicher Schiene (7, 11) erhöht.

11. Anlage (1) zur Prozessierung von Halbleiterbauelementen nach einem der vorstehenden Ansprüche, **dadurch gekennzeichnet, dass** die Hebeeinrichtung einen motorischen Antrieb umfasst.

## Claims

1. A system (1) for processing semiconductor components, comprising a lifting device (6) for a system part (8) or a system module (9), which is attached laterally next to or below or above the system part (8) or the system module (9), wherein the lifting device (6) comprises a telescopic rail for horizontally moving the system part (8) or system module (9), and wherein the telescopic rail comprises a movable rail (7) that can be raised via wedges (18a, 18b).

2. The system (1) for processing semiconductor components according to the preceding claim,
**characterized in that** the system (1) comprises at least one, preferably two lifting devices (6), each using a single drive to move the system part (8) or system module (9) only in a vertical direction and subsequently only in a horizontal direction.

3. The system (1) for processing semiconductor components according to the preceding claim,
**characterized in that** the telescopic rail comprises at least two interlocking gears (21a, 21b) that are arranged one above the other, each of the gears (21a, 21b) being meshed with a rack (20a, 20b) of the movable rail (7).

4. The system (1) for processing semiconductor components according to any one of the preceding claims, **characterized in that** the lifting device (6) is adapted so as to perform a vertical and horizontal movement when a single handling means (12) is actuated.

5. The system (1) for processing semiconductor components according to any one of the preceding claims, **characterized in that** the lifting device has a length of more than 1 m.

6. The system (1) for processing semiconductor components according to any one of the preceding claims, **characterized in that** the lifting device (6) comprises a drive with a threaded spindle (15).

7. The system (1) for processing semiconductor components according to claim 1, **characterized in that** the lifting device (6) comprises at least one, preferably two, most preferably a plurality of stamps (26) which are vertically movable via wedges (27) and/or via lever arms (29a, 29b).

8. The system (1) for processing semiconductor components according to the preceding claim,
**characterized in that** the lifting device (6) comprises a rail (24) from which the stamps (26) protrude at least in a raised state thereof.

9. The system (1) for processing semiconductor components according to any one of the preceding claims, **characterized in that** the lifting device (6) is designed to be detachable, in particular using a quick-release mechanism.

10. The system (1) for processing semiconductor components according to any one of the preceding claims, **characterized in that** the lifting device is in the form of a telescopic rail, and that two or more gears (21a, 21b) in combination with two toothed rails (20a, 20b) or toothings define a lever that increases the rigidity of the system of the fixed and movable rails (7, 11).

11. The system (1) for processing semiconductor components according to any one of the preceding claims, **characterized in that** the lifting device comprises a motor drive.

## Revendications

1. Installation (1) pour le traitement de composants semi-conducteurs, comportant un dispositif de levage (6) pour une partie d'installation (8) ou un module d'installation (9), lequel est monté latéralement à côté ou au-dessous ou au-dessus de la partie d'installation (8) ou du module d'installation (9), le dispositif de levage (6) comportant un rail télescopique pour le déplacement horizontal de la partie d'installation (8) ou du module d'installation (9), et le rail télescopique comporte un rail mobile (7), lequel est apte à être soulevé par des coins (18a, 18b).

2. Installation (1) pour le traitement de composants semi-conducteurs selon la revendication précédente, **caractérisée par le fait que** l'installation (1) comporte au moins un, de préférence deux dispositifs de levage (6) qui, au moyen d'un seul entraînement respectif, déplacent la partie d'installation (8) ou le module d'installation (9) seulement dans une direction verticale et ensuite seulement dans une direction horizontale.

3. Installation (1) pour le traitement de composants semi-conducteurs selon la revendication précédente, **caractérisée par le fait que** le rail télescopique comporte au moins deux roues dentées (21a, 21b) s'engrenant l'une dans l'autre et disposées l'une au-dessus de l'autre, les roues dentées (21a, 21b) s'engrenant chacune dans une crémaillère (20a, 20b) du rail mobile (7).

4. Installation (1) pour le traitement de composants semi-conducteurs selon l'une des revendications précédentes, **caractérisée par le fait que** le dispositif de levage (6) est conçu de telle sorte qu'il exécute un mouvement vertical et horizontal lors de l'actionnement d'un seul moyen de manipulation (12).

5. Installation (1) pour le traitement de dispositifs semi-conducteurs selon l'une des revendications précédentes, **caractérisée par le fait que** le dispositif de levage a une longueur de plus de 1 mètre.

6. Installation (1) pour le traitement de dispositifs semi-conducteurs selon l'une des revendications précédentes, **caractérisée par le fait que** le dispositif de levage (6) comporte un entraînement avec une tige filetée (15).

7. Installation (1) pour le traitement de composants semi-conducteurs selon la revendication 1, **caractérisée par le fait que** le dispositif de levage (6) comporte au moins un, de préférence deux, de manière particulièrement préférée une pluralité de tampons (26), lesquels sont déplaçables verticalement par des coins (27) et/ou des bras de levier (29a, 29b).

8. Installation (1) pour le traitement de composants semi-conducteurs selon la revendication précédente, **caractérisée par le fait que** le dispositif de levage (6) comporte un rail (24) duquel les tampons (26) dépassent au moins dans un état soulevé.

9. Installation (1) pour le traitement de composants semi-conducteurs selon l'une des revendications précédentes, **caractérisée par le fait que** le dispositif de levage (6) est conçu de manière amovible, en particulier au moyen d'un dispositif de serrage rapide.

10. Installation (1) pour le traitement de composants semi-conducteurs selon l'une des revendications précédentes, **caractérisé par le fait que** le dispositif de levage est conçu comme rail télescopique, et où au moins deux roues dentées (21a, 21b) forment, en liaison avec deux crémaillères (20a, 20b) ou dentures, un levier qui augmente la rigidité du système de rails fixe et mobile (7, 11).

11. Installation (1) pour le traitement de composants semi-conducteurs selon la revendication précédente, **caractérisée par le fait que** le dispositif de levage comporte un entraînement motorisé.
